# EUROPEAN PATENT SPECIFICATION

(11) **EP 4 199 047 B1**
(45) Date of publication and mention of the grant of the patent: **10.04.2024**
(21) Application number: 22213362.1
(22) Date of filing: 14.12.2022
(51) Int. Cl.: H01L 21/67

(54) **GAS MANAGEMENT ASSEMBLY FOR HIGH PRESSURE HEAT-TREATMENT APPARATUS**
GASVERWALTUNGSANORDNUNG FÜR HOCHDRUCKWÄRMEBEHANDLUNGSVORRICHTUNG
ENSEMBLE DE GESTION DE GAZ POUR APPAREIL DE TRAITEMENT THERMIQUE HAUTE PRESSION

(30) Priority: 20.12.2021 KR 20210182552
(43) Date of publication of application: 21.06.2023
(73) Proprietor: HPSP Co., Ltd., Suwon-si, Gyeonggi-do (KR)
(72) Inventor: LIM, Kun Young, (101-dong,1301-ho), 43 Wongol-ro,Uiwang-si,Gyeonggi-do (KR)
(74) Representative: von Bülow & Tamada

(56) References cited:
- JP-A- 2019 057 641
- US-A- 5 271 732
- US-A1- 2019 148 178

## Description

### BACKGROUND

### Field

The present disclosure relates to a system comprising a gas management assembly and a high pressure heat-treatment apparatus.

The gas management assembly is configured for being used with the high pressure heat-treatment apparatus, and performs gas supply and exhaust for the high pressure heat-treatment apparatus.

### Description of the Related Art

In general, an ion implantation process during semiconductor fabrication may cause damage to an interface of a wafer. Annealing may be a process of healing the damage to the corresponding wafer through heat treatment. In addition to the annealing, the heat treatment may also be performed on the wafer when activating impurities, when performing a chemical vapor deposition (CVD) process to form a thin film, and when performing an ohmic contact alloy process.

During the heat treatment, a gas may act on the wafer. The gas may be supplied at a high pressure to a chamber in which the wafer is accommodated. After the heat treatment is finished, the used gas may be exhausted from the chamber. After the gas is exhausted, the heat-treated wafer may be withdrawn from the chamber. A new wafer and the gas may then be provided to the chamber for the next heat treatment.

A highly flammable gas such as hydrogen or deuterium may be used as the gas for the heat treatment. The used gas may remain in the chamber while being exhausted. When the residual gas meets oxygen flowing into the chamber, a possibility of an explosion or the like may not be ruled out.

The following documents are disclosed as pertinent illustrations of the prior art:

Document US 2019/148178 A1 discloses a gas delivery system for high pressure processing chamber which is configured for processing a layer on a substrate.

Document JP 2019 057641 A discloses an exposure device capable of improving efficiency of exposure processing of a substrate to be processed in a processing device.

Document US 5271 732 A discloses a heat treatment apparatus comprising an inert gas filled lock chamber, configured to avoid natural oxide film formation.

### SUMMARY

An object of the present disclosure is to provide a system comprising a gas management assembly and a high pressure heat-treatment apparatus. The gas management assembly is configured for being used with a high pressure heat-treatment apparatus.

It structurally prevents a risk that may be caused by a residual gas remaining in a chamber.

According to an embodiment of the present disclosure, a gas management assembly for a high pressure heat-treatment apparatus includes: a housing having an inner space; a gas supply module disposed in the inner space and configured to supply a gas to internal and external chambers of the high pressure heat-treatment apparatus; a gas exhaust module disposed in the inner space and configured to exhaust the gas caused by heat treatment of an object from the internal chamber; a detection module connected to the gas exhaust module in the inner space and configured to detect the residual gas remaining in the internal chamber; and a control module configured to control at least one of the gas supply module and the gas exhaust module based on a detection result of the residual gas by the detection module.

The gas exhaust module may include a gas exhaust line communicating with the internal chamber to guide the gas from the internal chamber to the outside, and the detection module may include a branch line branching from the gas exhaust line, a detection valve disposed in the inner space and installed in the branch line, and a gas detector configured to detect the residual gas from a flow of the gas flowing from the internal chamber as the detection valve is opened.

The gas detector may include at least one of an active gas detector and an inflow gas detector, the active gas detector may be configured to detect an active gas injected into the internal chamber to act on the object, and the inflow gas detector may be configured to detect an inflow gas flowing into the internal chamber from the outside.

The detection module may further include a pressure regulator disposed before the active gas detector and configured to lower a pressure of the flow of the gas flowing into the active gas detector to a reference pressure or less.

The control module may control the active gas detector to be operated after the heat treatment of the object, and control the inflow gas detector to be operated before the heat treatment of the object.

The control module may be configured to control the gas supply module to supply an inert gas to the internal chamber when operating the gas detector.

The assembly may further include a discharge module configured to discharge the gas from the inner space, wherein the gas detector communicates with the discharge module.

The assembly may further include an inflow module configured to allow external air to flow into the inner space, wherein based on an operation of the discharge module, the external air flows into the inner space through the inflow module and is then discharged through the discharge module.

The assembly may further include a detection module configured to detect an environment of the inner space, wherein the control module is configured to stop gas supply performed by the gas supply module when determining that gas leak occurs in the inner space from the detection result by the detection module.

According to another embodiment of the present disclosure, a gas management assembly for a high pressure heat-treatment apparatus includes: a housing having an inner space; a gas exhaust module disposed in the inner space and configured to exhaust a gas caused by heat treatment of an object from a chamber of the high pressure heat-treatment apparatus; a detection module connected to the gas exhaust module in the inner space and configured to detect the residual gas remaining in the chamber at at least one time point before and after the heat treatment of the object; and a control module configured to operate the gas exhaust module to exhaust the gas from the chamber based on a detection result of the residual gas by the detection module, wherein the residual gas is input to the detection module at a pressure lower than an exhaust pressure of the gas caused by the heat treatment.

The gas exhaust module may have a gas exhaust line communicating with the chamber to guide the gas from the chamber to the outside, and the detection module may include a branch line branching from the gas exhaust line, a detection valve disposed in the inner space and installed in the branch line, and a gas detector configured to detect the residual gas from a flow of the gas flowing from the chamber as the detection valve is opened.

The gas detector may include at least one of an active gas detector and an inflow gas detector, the active gas detector may be configured to detect an active gas injected into the chamber to act on the object, and the inflow gas detector may be configured to detect an inflow gas flowing into the chamber from the outside.

The assembly may further include: a gas supply module disposed in the inner space and configured to supply the gas for the heat treatment of the object to the chamber; and a detection module configured to detect an environment of the inner space, wherein the control module is configured to stop gas supply performed by the gas supply module when determining that gas leak occurs in the inner space from the detection result by the detection module.

The assembly may further include a discharge module configured to discharge the gas from the inner space under control of the control module, wherein the gas detector communicates with the discharge module.

### BRIEF DESCRIPTION OF THE DRAWINGS

FIG. 1 is a conceptual diagram showing a gas management assembly 100 configured to be used with a high pressure heat-treatment apparatus according to an embodiment of the present disclosure.
FIG. 2 is a block diagram for explaining a control configuration of the gas management assembly 100 configured to be used with a high pressure heat-treatment apparatus of FIG. 1.
FIG. 3 is a flowchart for explaining a control method of the gas management assembly 100 for a high pressure heat-treatment apparatus of FIG. 1.
FIG. 4 is a conceptual diagram of a gas management assembly 200 configured to be used with a high pressure heat-treatment apparatus according to another embodiment of the present disclosure.

### DETAILED DESCRIPTION

Hereinafter, embodiments of the present disclosure are described in detail with reference to the accompanying drawings. Throughout the present disclosure, components that are the same as or similar to each other are denoted by reference numerals that are the same as or similar to each other, and a description thereof is replaced by the first description, even in a different embodiment.

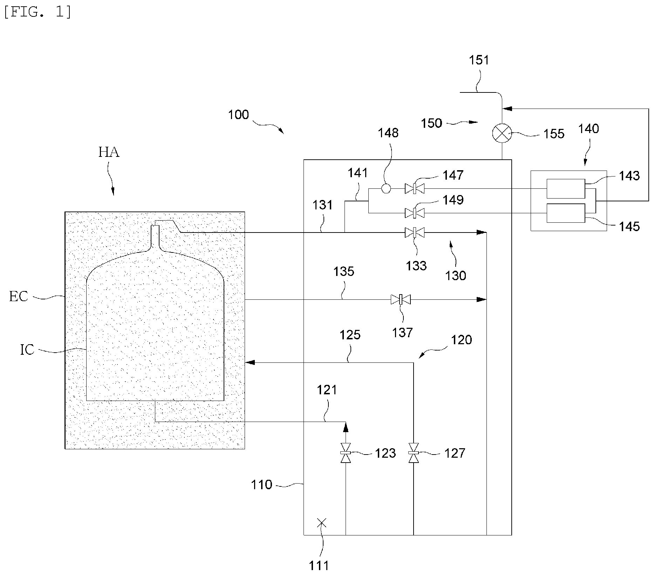

FIG. 1 is a conceptual diagram showing a gas management assembly 100 configured to be used with a high pressure heat-treatment apparatus according to an embodiment of the present disclosure.

Referring to the drawing, the gas management assembly 100 configured to be used with a high pressure heat-treatment apparatus may be a component for not only supplying/exhausting a gas to/from a high pressure heat-treatment apparatus HA, but also detecting the residual gas remaining in the apparatus HA.

First, the description describes the high pressure heat-treatment apparatus HA as follows. The high pressure heat-treatment apparatus HA may have an internal chamber IC and an external chamber EC.

The internal chamber IC may have an accommodation space accommodating an object to be heat-treated. The internal chamber IC may be made of a non-metallic material, for example, quartz, to reduce a possibility that contaminants (particles) occur in a high-pressure and high-temperature process environment. Although simplified in the drawing, a door (not shown) for opening the accommodation space may be positioned at a lower end of the internal chamber IC. The accommodation space may be opened as the door descends, and the object may be put into the internal chamber IC while being mounted on a holder (not shown). As a heater (not shown) disposed outside the internal chamber IC is operated, the internal chamber IC may be heated up to several hundred degrees Celsius. The object may be, for example, a wafer. In this case, the holder may be a wafer boat which may stack the wafers in a plurality of layers.

The external chamber EC may surround the internal chamber IC. Unlike the internal chamber IC, the external chamber EC is free from a problem of contamination of the object, and may thus be made of a metal material. The external chamber EC may also have a door at a lower portion, and the door of the internal chamber IC and that of the external chamber EC may be opened while descending together.

Now, the description describes the gas management assembly 100 as follows. The gas management assembly 100 may include a housing 110, a gas supply module 120, a gas exhaust module 130, a detection module 140, and a discharge module 150.

The housing 110 may have an inner space 111. The housing 110 may have a substantially rectangular parallelepiped body. The gas supply module 120 and the gas exhaust module 130 may be installed in the inner space 111. The housing 110 may include a door (not shown) through which an operator may access the inner space 111 to replace/repair the gas supply module 120 described below.

The gas supply module 120 may be configured to supply the gas to the high pressure heat-treatment apparatus HA, specifically to the chambers IC and EC. The gas supply module 120 may communicate with a utility line (gas supply line) of a semiconductor factory. The gas supply module 120 may include a first gas supply line 121 communicating with the internal chamber IC and a second gas supply line 125 communicating with the external chamber EC.

Through the first gas supply line 121, the internal chamber IC may be selectively supplied with the gas for the heat treatment of the object, for example, hydrogen/deuterium, fluorine, ammonia, chlorine, nitrogen, or the like. Here, hydrogen/deuterium or the like is an active gas, and nitrogen is an inert gas. The active gas and the inert gas may act on the object while being mixed with each other in the internal chamber IC. Through the second gas supply line 125, the inert gas such as nitrogen or argon may be supplied to the external chamber EC. The gas injected into the external chamber EC may be specifically filled in a space between the external chamber EC and the internal chamber IC.

The gas supplied to the internal and external chambers IC and EC may be at pressures higher than that of the atmosphere, and form, for example, high pressures ranging from several to several tens of atmospheres. When a first pressure indicates the pressure of the gas supplied to the internal chamber IC and a second pressure indicates the pressure of the gas supplied to the external chamber EC, the second pressure may be set in relation with the first pressure. For example, the second pressure may be set to be slightly higher than the first pressure. Such a pressure difference may prevent gas leak from the internal chamber IC and damage to the internal chamber IC.

A gas supply valve 123 may be installed in the first gas supply line 121 to establish and maintain a relationship between the first pressure and the second pressure. The gas supply valve 123 may supply the gas while measuring an amount of the gas input to the internal chamber IC. Another gas supply valve 127 may be installed in the second gas supply line 125. Opening and closing of the gas supply valve 127 may be controlled based on the pressure of the gas in the external chamber EC. Although identically shown in the form of simple valves for convenience, and the gas supply valve 123 and the gas supply valve 127 may have specific actions different from each other.

The gas exhaust module 130 is configured to exhaust the gas caused by the heat treatment of the object from the chambers IC and EC. The gas caused by the heat treatment may have a temperature higher than an ignition point of the active gas based on a progress of a high-temperature process. The gas exhaust module 130, specifically, a gas exhaust line thereof, may communicate with a utility line (gas exhaust line) of the semiconductor factory.

The gas exhaust module 130 may specifically include a first gas exhaust line 131 for exhausting the gas from the internal chamber IC and a second gas exhaust line 135 for exhausting the gas from the external chamber EC. The first gas exhaust line 131 may communicate with the top of the internal chamber IC and may also extend out of the external chamber EC. An exhaust valve 133 may be installed in the first gas exhaust line 131. The second gas exhaust line 135 may communicate with the external chamber EC and may also have an exhaust valve 137. The second gas exhaust line 135 may be incorporated into the first gas exhaust line 131. In this case, the active gas exhausted along the first gas exhaust line 131 may be diluted with the inert gas exhausted along the second gas exhaust line 135.

The detection module 140 is configured to detect the residual gas remaining in the chambers IC and EC, mainly in the internal chamber IC, even when the gas exhaust module 130 is operated. The detection module 140 may have a branch line 141 branching from the gas exhaust module 130, specifically, the first gas exhaust line 131 in the inner space 111.

Gas detectors 143 and 145 may be installed in the branch line 141. The gas detectors 143 and 145 may receive a flow of the gas flowing from the internal chamber IC and detect the residual gas. In detail, the gas detectors 143 and 145 may include the active gas detector 143 and the inflow gas detector 145. The active gas detector 143 may detect the active gas such as hydrogen or deuterium, remaining in the internal chamber IC. The inflow gas detector 145 may detect an inflow gas flowing from the outside, specifically oxygen, when the door of the internal chamber IC (or the door of the external chamber EC) is opened. The gas detectors 143 and 145 may communicate with a discharge duct 151 described below. The type or number of the gas detectors 143 and 145 is not limited to that exemplified in this embodiment, and more/less number of gas detectors may be employed as needed.

Detection valves 147 and 149 may be installed in the branch line 141 to regulate the flow of the gas flowing from the internal chamber IC to the gas detectors 143 and 145. The detection valves 147 and 149 may respectively correspond to the active gas detector 143 and the inflow gas detector 145. The detection valves 147 and 149 may not be opened during a process of exhausting the gas caused by the heat treatment. Accordingly, a high exhaust pressure of the gas caused by the heat treatment may not act on the gas detectors 143 and 145. Instead, a gas having a much lower pressure than the exhaust pressure of the gas caused by the heat treatment may be input to the gas detectors 143 and 145.

As described above, even when the low-pressure gas is input to the gas detectors 143 and 145, the active gas detector 143 may allow only a gas having a lower-pressure than the corresponding gas. This configuration is possible by a pressure regulator 148 installed before the detection valve 147. The pressure regulator 148 may lower the pressure of the gas passing through the detection valve 147 to a reference pressure or less. The active gas detector 143 is a sensitive component for detecting the active gas having a parts per million (PPM) level, and may be required to be additionally protected by the pressure regulator 148. Although described as being installed to correspond to the active gas detector 143, the pressure regulator 148 may also be installed to correspond to the inflow gas detector 145 based on a design.

The gas detectors 143 and 145 may be disposed outside the housing 110. On the other hand, a connection portion of the branch line 141 to the first gas exhaust line 131 and the detection valves 147 and 149 may be disposed in the inner space 111. Such a disposition is arranged to respond to a possibility that the active gas leaks from the connection portion and the detection valves 147 and 149. The high exhaust pressure of the gas caused by the heat treatment may act on the connection portion and the detection valves 147 and 149, and a possibility thus exists that the active gas leaks from the corresponding portions. The gas detectors 143 and 145 may not have to be disposed outside the housing 110, and may be disposed in the inner space 111.

The discharge module 150 is configured to discharge the gas from the inner space 111. The gas in the inner space 111 may include the active gas leaking from the gas supply module 120 or the gas exhaust module 130.

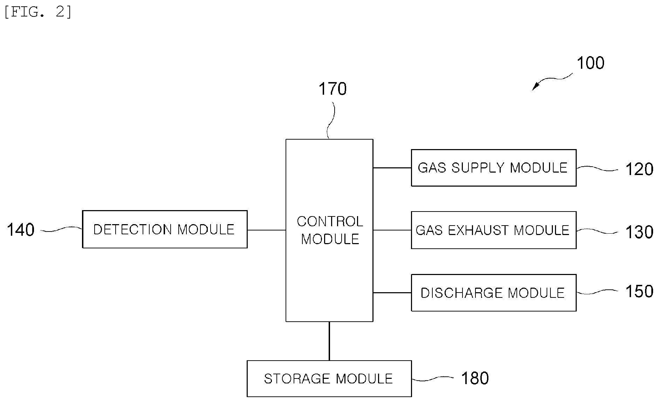

The discharge module 150 may include the discharge duct 151 communicating with the inner space 111. The discharge duct 151 may be connected to the utility line (gas exhaust line) of the semiconductor factory. A gate valve 155 may be installed in the discharge duct 151. When the gas in the inner space 111 is required to be discharged, the gate valve 155 may be opened under control of a control module 170 (see FIG. 2) .

Unlike the above, the detection module 140 may detect the residual gas in the external chamber EC. In this case, the branch line 141 may be connected to the second gas exhaust line 135. A method of detecting the residual gas in the external chamber EC may be substantially the same as the method described in this specification focusing on the internal chamber IC.

The description describes a control configuration of the gas management assembly 100 with reference to FIG. 2. FIG. 2 is a block diagram for explaining the control configuration of the gas management assembly 100 configured to be used with a high pressure heat-treatment apparatus of FIG. 1.

Referring to the drawing (and FIG. 1), the gas management assembly 100 may further include the control module 170 and a storage module 180 in addition to the gas supply module 120, the gas exhaust module 130, and the detection module 140, described above.

The control module 170 is configured to control the gas supply module 120, the gas exhaust module 130, the detection module 140, the discharge module 150, or the like. In detail, the control module 170 controls the gas supply module 120, the gas exhaust module 130, or the like, based on a detection result of the residual gas by the detection module 140.

The storage module 180 may be configured to store data, programs, or the like that the control module 170 may refer to for the control. The storage module 180 may include at least one type of storage medium among a flash memory, a hard disk, a magnetic disk, and an optical disk.

Through this configuration, the control module 170 controls the gas supply module 120 to supply the inert gas to the internal chamber IC when the detection module 140 is operated. This control is to induce the residual gas remaining in the internal chamber IC to flow to the gas detectors 143 and 145.

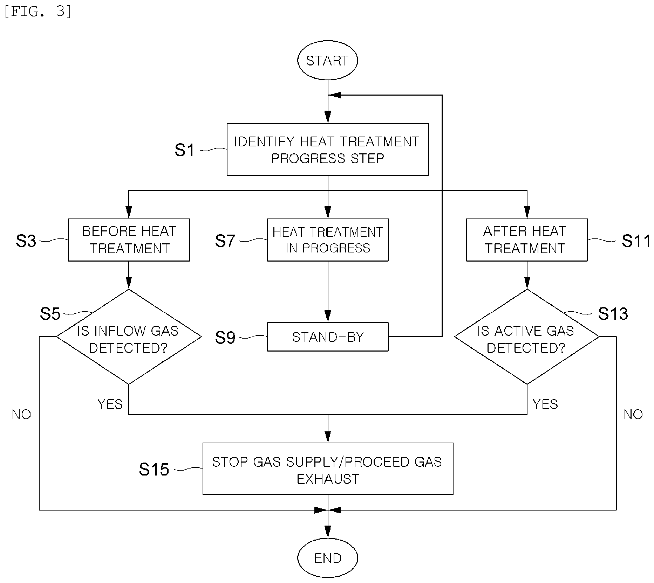

The description describes more specific details of the control module 170 that controls detection of the residual gas and controls the gas supply module 120 based on a detection result with reference to FIG. 3. FIG. 3 is a flowchart for explaining a control method of the gas management assembly 100 configured to be used with a high pressure heat-treatment apparatus of FIG. 1.

Referring to the drawing (and FIGS. 1 and 2), the control module 170 may identify a heat treatment progress step in progress to respond differently to each step of the heat treatment process in the high pressure heat-treatment apparatus HA (S1).

When it is a step before the heat treatment (S3), the control module 170 may operate the inflow gas detector 145 to detect whether the inflow gas remains in the internal chamber IC (S5). Here, the step before the heat treatment may be, in detail, a time point when a new wafer is loaded into the internal chamber IC and the doors of the chambers IC and EC are closed. This step may be before the gas supply and heating to the chambers IC and EC are performed.

When it is a step of the heat treatment in progress (S7), the control module 170 may determine the heat treatment progress step again (S1) after standing-by for a predetermined time (S9).

When it is a step after the heat treatment (S11), the control module 170 may operate the active gas detector 143 to detect whether the active gas remains in the internal chamber IC (S13). Here, the step after the heat treatment may be, in detail, a time point when the gas in the chambers IC and EC is exhausted after the heat treatment on the loaded wafer is performed. In this case, the doors of the chambers IC and EC are not opened, and the heat-treated wafer may still be positioned in the chambers IC and EC.

When the gas detectors 143 and 145 detect the residual gas before and after the heat treatment, the control module 170 may stop or may not resume an operation of the gas supply module 120 (S15) . This configuration may prevent the gas supply module 120 from supplying the active gas and the inert gas to the internal chamber IC (and the external chamber EC) of the high pressure heat-treatment apparatus HA.

The control module 170 operates the gas exhaust module 130 to exhaust the gas in the internal chamber IC (and the external chamber EC) (S15) . This control is to exhaust the active gas and/or the inflow gas existing in the internal chamber IC, thereby eliminating a risk of the residual gas.

When the gas detectors 143 and 145 detect no residual gas before and after the heat treatment, the control module 170 may end the detection of the residual gas.

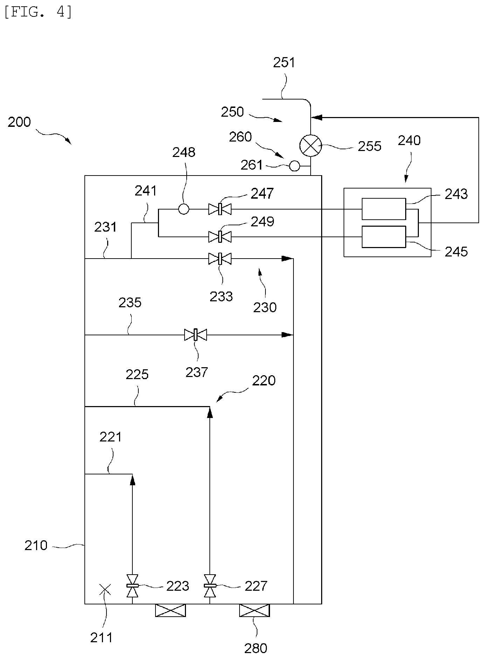

The description describes another type of the gas management assembly 100 with reference to FIG. 4.

FIG. 4 is a conceptual diagram of a gas management assembly 200 for a high pressure heat-treatment apparatus according to another embodiment of the present disclosure.

Referring to the drawing, the gas management assembly 200 is substantially the same as the gas management assembly 100 of an embodiment, and different by further including a detection module 260 and an inflow module 280. Hereinafter, the description focuses on a configuration different from that in an embodiment. In addition, the description omits the configuration of the high pressure heat-treatment apparatus HA (see FIG. 1) to make the drawing simple.

The detection module 260 may be configured to detect an environment of an inner space 211, and include a gas sensor 261. The gas detector 261 may be configured to detect the active gas leaking in the inner space 211.

The inflow module 280 may be configured to allow external air to flow into the inner space 211. The inflow module 280 may be a damper that is opened and closed by manual manipulation or the control of the control module 170 (see FIG. 2) . In the state where the damper is opened, the external air may flow into the inner space 211 by a negative pressure generated by an operation of a discharge module 250.

The inflow module 280 may be disposed opposite to the discharge module 250 with respect to the housing 210. Referring to the drawing, the discharge module 250 may be disposed above the housing 210, while the inlet module 280 may be disposed below the housing 210. This disposition is to lengthen a flow path of the external air in the housing 210 for the leaking gas to be effectively discharged in all areas of the inner space 211.

Through this configuration, the external air may continuously flow into the inner space 211 by the opening of the inflow module 280 and the operation of the discharge module 250. The external air may cause the gas in the inner space 211 to be discharged through the discharge module 250. For example, the leaking gas may be discharged through the discharge module 250 even when slight gas leak occurs in the connection portion of the branch line 241 and the detection valves 247 and 249. Accordingly, a concentration of the active gas in the inner space 211 may be managed below a set concentration.

During the operation of the discharge module 250, the control module 170 may determine a current concentration of the active gas through the gas detector 261. When the current concentration of the active gas in the inner space 211 exceeds the set concentration, the control module 170 may determine that a significant level of gas leak occurs and take an additional measure. The control module 170 may stop supplying the gas to the chambers 110 and 120 by closing the gas supply valve 223, for example. Accordingly, the active gas is prevented from entering the inner space 211 either. The gas management assembly 200 may be safely operated by these additional measures even when a significant level of the gas leak occurs in the connection portion and detection valves 247 and 249.

The system comprising the gas management assembly and the high pressure heat-treatment apparatus is defined by the appended claims. Some embodiment variations can be accepted as long as they belong to the scope of said appended claims.

As set forth above, the gas management assembly, comprised in the system claimed in claim 1 and configured for being used with a high pressure heat-treatment apparatus according to the present disclosure, includes the gas supply module for supplying the gas to the chamber of the high pressure heat-treatment apparatus and the gas exhaust module for exhausting the gas from the chamber, which are provided in the housing, as well as the detection module connected to the gas exhaust module in the housing and detecting the residual gas remaining in the chamber and the control module for controlling the gas supply module and the gas exhaust module based on the detection result, thereby stopping the heat treatment process to exhaust the residual gas when detecting the residual gas in the chamber. In this way, the gas management assembly comprised in the system claimed in claim 1 may structurally prevent the risk that may be caused by the residual gas remaining in the chamber.

## Claims

1. A system comprising a gas management assembly (100, 200) and a high pressure heat-treatment apparatus (HA), the gas management assembly configured for being used with the high pressure heat-treatment apparatus, the assembly comprising:
a housing (110, 210) having an inner space (111, 211);
a gas supply module (120) disposed in the inner space and configured to supply a gas to internal chamber (IC) and external chamber (EC) of the high pressure heat-treatment apparatus;
a gas exhaust module (130, 230) disposed in the inner space and configured to exhaust the gas caused by heat treatment of an object from the internal chamber;
a detection module (140, 240) connected to the gas exhaust module in the inner space and configured to detect the residual gas remaining in the internal chamber; and
a control module (170) configured to control at least one of the gas supply module and the gas exhaust module based on a detection result of the residual gas by the detection module.

2. The assembly of claim 1, wherein the gas exhaust module includes a gas exhaust line communicating with the internal chamber to guide the gas from the internal chamber to the outside, and
the detection module includes
a branch line branching from the gas exhaust line,
a detection valve disposed in the inner space and installed in the branch line, and
a gas detector configured to detect the residual gas from a flow of the gas flowing from the internal chamber as the detection valve is opened.

3. The assembly of claim 2, wherein the gas detector includes at least one of an active gas detector and an inflow gas detector,
the active gas detector is configured to detect an active gas injected into the internal chamber to act on the object, and
the inflow gas detector is configured to detect an inflow gas flowing into the internal chamber from the outside.

4. The assembly of claim 3, wherein the detection module further includes a pressure regulator disposed before the active gas detector and configured to lower a pressure of the flow of the gas flowing into the active gas detector to a reference pressure or less.

5. The assembly of claim 3, wherein the control module controls the active gas detector to be operated after the heat treatment of the object, and
controls the inflow gas detector to be operated before the heat treatment of the object.

6. The assembly of claim 2, wherein the control module is configured to control the gas supply module to supply an inert gas to the internal chamber when operating the gas detector.

7. The assembly of claim 2, further comprising a discharge module configured to discharge the gas from the inner space,
wherein the gas detector communicates with the discharge module.

8. The assembly of claim 7, further comprising an inflow module configured to allow external air to flow into the inner space,
wherein based on an operation of the discharge module, the external air flows into the inner space through the inflow module and is then discharged through the discharge module.

9. The assembly of claim 8, further comprising a detection module configured to detect an environment of the inner space,
wherein the control module is configured to stop gas supply performed by the gas supply module when determining that gas leak occurs in the inner space from the detection result by the detection module.

10. A system comprising a gas management assembly (100, 200) and a high pressure heat-treatment apparatus (HA), the gas management assembly configured for being used with the high pressure heat-treatment apparatus, the assembly comprising:
a housing (110, 210) having an inner space (111, 211);
a gas exhaust module (130, 230) disposed in the inner space and configured to exhaust a gas caused by heat treatment of an object from a chamber of the high pressure heat-treatment apparatus;
a detection module (140, 240) connected to the gas exhaust module in the inner space and configured to detect the residual gas remaining in the chamber at at least one time point before and after the heat treatment of the object; and
a control module (170) configured to operate the gas exhaust module to exhaust the gas from the chamber based on a detection result of the residual gas by the detection module,
wherein the residual gas is input to the detection module at a pressure lower than an exhaust pressure of the gas caused by the heat treatment.

11. The assembly of claim 10, wherein the gas exhaust module has a gas exhaust line communicating with the chamber to guide the gas from the chamber to the outside, and
the detection module includes
a branch line branching from the gas exhaust line,
a detection valve disposed in the inner space and installed in the branch line, and
a gas detector configured to detect the residual gas from a flow of the gas flowing from the chamber as the detection valve is opened.

12. The assembly of claim 11, wherein the gas detector includes at least one of an active gas detector and an inflow gas detector,
the active gas detector is configured to detect an active gas injected into the chamber to act on the object, and
the inflow gas detector is configured to detect an inflow gas flowing into the chamber from the outside.

13. The assembly of claim 10, further comprising:
a gas supply module disposed in the inner space and configured to supply the gas for the heat treatment of the object to the chamber; and
a detection module configured to detect an environment of the inner space,
wherein the control module is configured to stop gas supply performed by the gas supply module when determining that gas leak occurs in the inner space from the detection result by the detection module.

14. The assembly of claim 11, further comprising a discharge module configured to discharge the gas from the inner space under control of the control module,
wherein the gas detector communicates with the discharge module.

## Patentansprüche

1. Ein System, bestehend aus einer Gasverwaltungseinheit (100, 200) und einer Hochdruck-Wärmebehandlungsanlage (HA), wobei die Gasverwaltungseinheit für die Verwendung mit der Hochdruck-Wärmebehandlungsanlage konfiguriert ist, die Einheit umfasst:
ein Gehäuse (110, 210) mit einem Innenraum (111, 211);
ein Gasversorgungsmodul (120), das im Innenraum angeordnet und konfiguriert ist, um ein Gas an die Innenkammer (IC) und die Außenkammer (EC) der Hochdruck-Wärmebehandlungsanlage zu liefern;
ein Gasabgasmodul (130, 230), das im Innenraum angeordnet und konfiguriert ist, um das durch die Wärmebehandlung eines Objekts verursachte Gas aus der Innenkammer abzuleiten;
ein Detektionsmodul (140, 240), das mit dem Gasabgasmodul im Innenraum verbunden und konfiguriert ist, um das in der Innenkammer verbleibende Restgas zu erkennen; und
ein Steuerungsmodul (170), konfiguriert, um basierend auf einem Detektionsergebnis des Restgases durch das Detektionsmodul mindestens eines der Gasversorgungs- und das Gasabgasmodul zu steuern.

2. Die Einheit von Anspruch 1, wobei das Gasabgasmodul eine Gasabgasleitung umfasst, die mit der Innenkammer kommuniziert, um das Gas von der Innenkammer nach außen zu leiten, und das Detektionsmodul umfasst:
eine Abzweigleitung, die von der Gasabgasleitung abzweigt,
ein Detektionsventil, das im Innenraum angeordnet und in der Abzweigleitung installiert ist, und
einen Gasdetektor, konfiguriert, um das Restgas aus einem Fluss des Gases zu erkennen, der aus der Innenkammer fließt, während das Detektionsventil geöffnet ist.

3. Die Einheit von Anspruch 2, wobei der Gasdetektor mindestens einen aktiven Gasdetektor und einen Einflussgasdetektor umfasst, der aktive Gasdetektor ist konfiguriert, um ein aktives Gas zu erkennen, das in die Innenkammer injiziert wird, um auf das Objekt einzuwirken, und der Einflussgasdetektor ist konfiguriert, um ein Einflussgas zu erkennen, das von außen in die Innenkammer fließt.

4. Die Einheit von Anspruch 3, wobei das Detektionsmodul weiterhin einen Druckregler umfasst, der vor dem aktiven Gasdetektor angeordnet und konfiguriert ist, um einen Druck des Gasflusses, der in den aktiven Gasdetektor fließt, auf einen Referenzdruck oder weniger zu senken.

5. Die Einheit von Anspruch 3, wobei das Steuerungsmodul den aktiven Gasdetektor steuert, um nach der Wärmebehandlung des Objekts betrieben zu werden, und den Einflussgasdetektor steuert, um vor der Wärmebehandlung des Objekts betrieben zu werden.

6. Die Einheit von Anspruch 2, wobei das Steuerungsmodul konfiguriert ist, um das Gasversorgungsmodul zu steuern, um ein inertes Gas in die Innenkammer zu liefern, wenn der Gasdetektor betrieben wird.

7. Die Einheit von Anspruch 2, weiter umfassend ein Entlademodul, konfiguriert, um das Gas aus dem Innenraum abzuleiten, wobei der Gasdetektor mit dem Entlademodul kommuniziert.

8. Die Einheit von Anspruch 7, weiter umfassend ein Einflussmodul, konfiguriert, um externer Luft zu erlauben, in den Innenraum zu fließen, wobei basierend auf einem Betrieb des Entlademoduls, die externe Luft durch das Einflussmodul in den Innenraum fließt und dann durch das Entlademodul abgeleitet wird.

9. Die Einheit von Anspruch 8, weiter umfassend ein Detektionsmodul, konfiguriert, um eine Umgebung des Innenraums zu erkennen, wobei das Steuerungsmodul konfiguriert ist, die Gasversorgung, die vom Gasversorgungsmodul durchgeführt wird, zu stoppen, wenn bestimmt wird, dass ein Gasleck im Innenraum aus dem Detektionsergebnis durch das Detektionsmodul auftritt.

10. Ein System, bestehend aus einer Gasverwaltungseinheit (100, 200) und einer Hochdruck-Wärmebehandlungsanlage (HA), wobei die Gasverwaltungseinheit für die Verwendung mit der Hochdruck-Wärmebehandlungsanlage konfiguriert ist, die Einheit umfasst:
ein Gehäuse (110, 210) mit einem Innenraum (111, 211);
ein Gasabgasmodul (130, 230), das im Innenraum angeordnet und konfiguriert ist, um ein durch die Wärmebehandlung eines Objekts verursachtes Gas aus einer Kammer der Hochdruck-Wärmebehandlungsanlage abzuleiten;
ein Detektionsmodul (140, 240), das mit dem Gasabgasmodul im Innenraum verbunden und konfiguriert ist, um das in der Kammer verbleibende Restgas zu einem oder mehreren Zeitpunkten vor und nach der Wärmebehandlung des Objekts zu erkennen; und
ein Steuerungsmodul (170), konfiguriert, um das Gasabgasmodul zu betreiben, um das Gas aus der Kammer basierend auf einem Detektionsergebnis des Restgases durch das Detektionsmodul abzuleiten, wobei das Restgas mit einem Druck niedriger als ein Abgasdruck des durch die Wärmebehandlung verursachten Gases in das Detektionsmodul eingegeben wird.

11. Die Einheit von Anspruch 10, wobei das Gasabgasmodul eine Gasabgasleitung umfasst, die mit der Kammer kommuniziert, um das Gas von der Kammer nach außen zu leiten, und das Detektionsmodul umfasst eine Abzweigleitung, die von der Gasabgasleitung abzweigt,
ein Detektionsventil, das im Innenraum angeordnet und in der Abzweigleitung installiert ist, und
einen Gasdetektor, konfiguriert, um das Restgas aus einem Fluss des Gases zu erkennen, der aus der Kammer fließt, während das Detektionsventil geöffnet ist.

12. Die Einheit von Anspruch 11, wobei der Gasdetektor mindestens einen aktiven Gasdetektor und einen Einflussgasdetektor umfasst, der aktive Gasdetektor ist konfiguriert, um ein aktives Gas zu erkennen, das in die Kammer injiziert wird, um auf das Objekt einzuwirken, und der Einflussgasdetektor ist konfiguriert, um ein Einflussgas zu erkennen, das von außen in die Kammer fließt.

13. Die Einheit von Anspruch 10, weiter umfassend:
ein Gasversorgungsmodul, das im Innenraum angeordnet und konfiguriert ist, um das Gas für die Wärmebehandlung des Objekts in die Kammer zu liefern; und
ein Detektionsmodul, konfiguriert, um eine Umgebung des Innenraums zu erkennen,
wobei das Steuerungsmodul konfiguriert ist, die Gasversorgung, die vom Gasversorgungsmodul durchgeführt wird, zu stoppen, wenn bestimmt wird, dass ein Gasleck im Innenraum aus dem Detektionsergebnis durch das Detektionsmodul auftritt.

14. Die Einheit von Anspruch 11, weiter umfassend ein Entlademodul, konfiguriert, um das Gas aus dem Innenraum unter Kontrolle des Steuerungsmoduls abzuleiten, wobei der Gasdetektor mit dem Entlademodul kommuniziert.

## Revendications

1. Un système comprenant un ensemble de gestion de gaz (100, 200) et un appareil de traitement thermique à haute pression (HA), l'ensemble de gestion de gaz étant configuré pour être utilisé avec l'appareil de traitement thermique à haute pression, l'ensemble comprenant :
un boîtier (110, 210) ayant un espace intérieur (111, 211) ;
un module d'alimentation en gaz (120) disposé dans l'espace intérieur et configuré pour fournir un gaz à la chambre interne (IC) et à la chambre externe (EC) de l'appareil de traitement thermique à haute pression ;
un module d'évacuation de gaz (130, 230) disposé dans l'espace intérieur et configuré pour évacuer le gaz causé par le traitement thermique d'un objet de la chambre interne ;
un module de détection (140, 240) connecté au module d'évacuation de gaz dans l'espace intérieur et configuré pour détecter le gaz résiduel restant dans la chambre interne ; et
un module de contrôle (170) configuré pour contrôler au moins l'un du module d'alimentation en gaz et du module d'évacuation de gaz sur la base d'un résultat de détection du gaz résiduel par le module de détection.

2. L'ensemble de la revendication 1, où le module d'évacuation de gaz comprend une ligne d'évacuation de gaz communiquant avec la chambre interne pour guider le gaz de la chambre interne vers l'extérieur, et le module de détection comprend
une ligne de branchement se détachant de la ligne d'évacuation de gaz, une vanne de détection disposée dans l'espace intérieur et installée dans la ligne de branchement, et
un détecteur de gaz configuré pour détecter le gaz résiduel à partir d'un flux de gaz s'écoulant de la chambre interne lorsque la vanne de détection est ouverte.

3. L'ensemble de la revendication 2, où le détecteur de gaz comprend au moins un détecteur de gaz actif et un détecteur de gaz d'entrée, le détecteur de gaz actif étant configuré pour détecter un gaz actif injecté dans la chambre interne pour agir sur l'objet, et le détecteur de gaz d'entrée étant configuré pour détecter un gaz d'entrée s'écoulant dans la chambre interne depuis l'extérieur.

4. L'ensemble de la revendication 3, où le module de détection comprend également un régulateur de pression disposé avant le détecteur de gaz actif et configuré pour abaisser une pression du flux de gaz s'écoulant dans le détecteur de gaz actif à une pression de référence ou moins.

5. L'ensemble de la revendication 3, où le module de contrôle commande le détecteur de gaz actif pour qu'il soit opéré après le traitement thermique de l'objet, et commande le détecteur de gaz d'entrée pour qu'il soit opéré avant le traitement thermique de l'objet.

6. L'ensemble de la revendication 2, où le module de contrôle est configuré pour commander le module d'alimentation en gaz pour fournir un gaz inerte à la chambre interne lors de l'opération du détecteur de gaz.

7. L'ensemble de la revendication 2, comprenant en outre un module de décharge configuré pour décharger le gaz de l'espace intérieur, où le détecteur de gaz communique avec le module de décharge.

8. L'ensemble de la revendication 7, comprenant en outre un module d'entrée configuré pour permettre à l'air extérieur de s'écouler dans l'espace intérieur, où, sur la base d'une opération du module de décharge, l'air extérieur s'écoule dans l'espace intérieur à travers le module d'entrée puis est déchargé à travers le module de décharge.

9. L'ensemble de la revendication 8, comprenant en outre un module de détection configuré pour détecter un environnement de l'espace intérieur, où le module de contrôle est configuré pour arrêter l'alimentation en gaz effectuée par le module d'alimentation en gaz lorsqu'il détermine qu'une fuite de gaz se produit dans l'espace intérieur à partir du résultat de détection par le module de détection.

10. Un système comprenant un ensemble de gestion de gaz (100, 200) et un appareil de traitement thermique à haute pression (HA), l'ensemble de gestion de gaz étant configuré pour être utilisé avec l'appareil de traitement thermique à haute pression, l'ensemble comprenant :
un boîtier (110, 210) ayant un espace intérieur (111, 211) ;
un module d'évacuation de gaz (130, 230) disposé dans l'espace intérieur et configuré pour évacuer un gaz causé par le traitement thermique d'un objet d'une chambre de l'appareil de traitement thermique à haute pression ;
un module de détection (140, 240) connecté au module d'évacuation de gaz dans l'espace intérieur et configuré pour détecter le gaz résiduel restant dans la chambre à au moins un moment avant et après le traitement thermique de l'objet ; et
un module de contrôle (170) configuré pour faire fonctionner le module d'évacuation de gaz pour évacuer le gaz de la chambre sur la base d'un résultat de détection du gaz résiduel par le module de détection,
où le gaz résiduel est introduit dans le module de détection à une pression inférieure à une pression d'évacuation du gaz causé par le traitement thermique.

11. L'ensemble de la revendication 10, où le module d'évacuation de gaz a une ligne d'évacuation de gaz communiquant avec la chambre pour guider le gaz de la chambre vers l'extérieur, et le module de détection comprend
une ligne de branchement se détachant de la ligne d'évacuation de gaz, une vanne de détection disposée dans l'espace intérieur et installée dans la ligne de branchement, et
un détecteur de gaz configuré pour détecter le gaz résiduel à partir d'un flux de gaz s'écoulant de la chambre lorsque la vanne de détection est ouverte.

12. L'ensemble de la revendication 11, où le détecteur de gaz comprend au moins un détecteur de gaz actif et un détecteur de gaz d'entrée, le détecteur de gaz actif étant configuré pour détecter un gaz actif injecté dans la chambre pour agir sur l'objet, et le détecteur de gaz d'entrée étant configuré pour détecter un gaz d'entrée s'écoulant dans la chambre depuis l'extérieur.

13. L'ensemble de la revendication 10, comprenant en outre :
un module d'alimentation en gaz disposé dans l'espace intérieur et configuré pour fournir le gaz pour le traitement thermique de l'objet à la chambre ; et
un module de détection configuré pour détecter un environnement de l'espace intérieur,
où le module de contrôle est configuré pour arrêter l'alimentation en gaz effectuée par le module d'alimentation en gaz lorsqu'il détermine qu'une fuite de gaz se produit dans l'espace intérieur à partir du résultat de détection par le module de détection.

14. L'ensemble de la revendication 11, comprenant en outre un module de décharge configuré pour décharger le gaz de l'espace intérieur sous le contrôle du module de contrôle, où le détecteur de gaz communique avec le module de décharge.
